# EUROPÄISCHE PATENTSCHRIFT

(11) **EP 1 469 320 B1**
(45) Veröffentlichungstag und Bekanntmachung des Hinweises auf die Patenterteilung: **12.07.2006**
(21) Anmeldenummer: 04008602.7
(22) Anmeldetag: 08.04.2004
(51) Int. Cl.: G01R 31/3167, G01R 31/3183, G01R 31/28

(54) **Verfahren zur Generierung von Testersteuerungen**
Method for generating tester controls
Procédé de génération des commandes de testeur

(30) Priorität: 15.04.2003 DE 10317431
(43) Veröffentlichungstag der Anmeldung: 20.10.2004
(73) Patentinhaber: Rood Technology Deutschland GmbH + Co, 86720 Nördlingen (DE)
(72) Erfinder: Kotz, Anton, Dr., 86748 Marktoffingen (DE); Klein, Peter, 86744 Hainsfarth (DE); Bruckdorfer, Uwe, 73469 Riesbürg (DE); Haschka, Matthias, 73467 Kirscheim (DE); Feldmeyer, Kurt, 73469 Riesbürg (DE)
(74) Vertreter: Cremer, Ulrike Theresia

(56) Entgegenhaltungen:
- EP-A- 0 397 937
- EP-B- 0 827 608
- DE-A- 10 101 067

## Beschreibung

Die Erfindung betrifft ein Verfahren, durch das aus einer testumgebungsunabhängigen Vielzahl von Daten und Steueranweisungen ein testumgebungsabhängiges Steuerverfahren wird, das auf einer bestimmten Testumgebung für das Testen von ICs, welche analoge und digitale Schaltkreise vereint, lauffähig ist. Sie betrifft weiterhin eine zum Verfahren korrespondierende Steuerung.

Elektronische Schaltkreise, die als Integrierte Schaltungen, auch als IC bezeichnet, vorliegen, müssen, um eine entsprechende Sicherheit und geringe Ausfallwahrscheinlichkeit zu bieten, vor dem Einbau in Gehäuse oder vor dem Einbau auf Platinen getestet werden. Insbesondere bei Applikationen der ICs, die ein hohes Maß an Zuverlässigkeit bieten müssen, wie zum Beispiel im Automobilbau, der Telekommunikation oder in der Luft- und Raumfahrt, ist es häufig gefordert, dass eine nahezu vollständige Funktionstestabdeckung gewährleistet wird. Eine Funktionstestabdeckung ist eine Überprüfung, ob das zu testende IC alle vorgesehenen Funktionen tatsächlich anbietet und in allen Fällen auch die beabsichtigte Reaktion zeigt. Diese ICs haben häufig in ihrem Gehäuse Schaltkreise vereint, die sowohl analoge Signale als auch digitale Signale verarbeiten können.

Für das Testen solcher ICs werden Testumgebungen, die abgekürzt Tester mit Lastplatinen bezeichnen, eingesetzt, die von vielen, verschiedenen Anbietern bezogen werden können. Einige Tester sind so ausgelegt, dass sie nur analoge Schaltkreise testen können, andere wiederum können ausschließlich digitale Schaltkreise testen, ein weiterer Typ von Testern bietet analoge und digitale Testresourcen an. Beispielhaft seien hier die Tester T6673, T6683 der Anbieterin Advantest® Europe GmbH, die eine Niederlassung in 81929 München, Deutschland, hat, die Tester Octet™ der Anbieterin Credence Systems Corporation aus Fremont, CA 94539, USA, die Tester SZ 3650 und Falcon der Anbietern Credence-SZ GmbH, mit einer Niederlassung in der Wasserburger Str. 44, D 83123 Amerang, und die Anbieterin Teradyne Inc. , aus Bosten, MA 02118 - 2238, USA, genannt, die Tester Integra Flex anbietet. Jeder Tester ist in einer für ihn typischen Sprache bzw. Syntax, die davon abhängt, welcher Hersteller den Tester baut, für das zu testende IC zu programmieren. Die Programmierung eines Testers kann, je nach Umfang der beabsichtigten Funktionstestabdeckung, bis zu zwei Mannjahre dauern. Die Programmierung kann nur von solchen Programmierern durchgeführt werden, die nicht nur in der Lage sind, die Tester in ihrer jeweils eigenen Syntax zu programmieren, sondern darüber hinaus auch ein gutes Verständnis dafür entwickeln können, welche Tests wie durchzuführen sind, an welchen Betriebspunkten und unter welchen Testumgebungsbedingungen das zu testende IC am ehesten unerwünschte Erscheinungen zeigt und wie die Funktionalitäten des Testers auf die gewünschte Funktionstestabdeckung anwendbar sind.

Demgegenüber haben sich die Produktinnovationszyklen in den letzten Jahren immer weiter verkürzt, so dass teilweise, vorrangig im Telekommunikationssektor, die Phase eines Innovationszykluses selbst innerhalb von zwei Jahren abgeschlossen ist. Folglich steht die Steuerung für einen bestimmten Tester erst zur Verfügung, wenn der Innovationszyklus schon abgeschlossen ist. Daher gehen entgegen den Erwartungen der Nutzer ICs in ein Produkt ein, die eigentlich getestet sein sollten, aber aus Zeitmangel nicht mehr getestet werden können. Erschwerend kommt hinzu, dass entworfene Testprogramme nur auf einem Tester lauffähig sind. Soll aus Kapazitätsgründen beim Tester ein Wechsel von einem Tester auf einen anderen Tester, oder sogar von einer Testerfamilie auf eine andere Testerfamilie, durchgeführt werden, so ist in der Regel der neue Tester für die Testanforderungen komplett neu auszulegen. Für das Auslegen ist dann ein Entwickler zu bemühen, der den neuen Tester inklusive seiner Syntax genau kennt, es ist daher auf eine sehr begrenzte Zahl von Spezialisten zurückzugreifen, die schwer zu finden sind.

Um den aufgezeigten Schwierigkeiten teilweise entgegenzuwirken, sind aus der Patentliteratur vielfältige Ansätze bekannt. In EP 0 056 895 B1 wird vorgeschlagen, eine zentrale Prozessoreinrichtung mit einer universellen Sprache wie ATLAS zu programmieren und über IEEE 488 Busse die zu kompilierenden Anweisungen an verschiedene abhängige Prozessoren zu übertragen, die über eine Schaltmatrix das jeweilige Testsignal an die Einheit unter Test (UUT oder DUT), also das IC, weiterleiten. Zusammenfassend kann gesagt werden, dass aus EP 0 056 895 B1 von 1981 zu entnehmen ist, auf einem Zentralprozessor, der in einer Hochsprache zu programmieren ist, werden die Testanweisungen für ein spezielles Testerbausteinnetzwerk verarbeitet, deren einzelne Bausteine alle auf eine DUT ausgerichtet sind. Insgesamt ist ein Tester beschrieben, der mit einer Vielzahl von Prozessoren auskommt, die unterschiedliche Aufgaben wahrnehmen, um Spannungen, Ströme oder auch Frequenzen zu generieren und zu messen.

Aus der US 5 206 582 ist zu entnehmen, dass schon vor mehr als zehn Jahren immer wieder versucht wurde, den Testaufwand zu reduzieren. Zu diesem Zeitpunkt wurden einzelne Transistoren getestet, die noch nicht vereinzelt auf einem gemeinsamen Wafer einer Testumgebung dargeboten worden sind. Die Testaufgaben orientierten sich an dem Produktionsprozess für einzelne Transistoren, das heißt, in einem Eingabeblatt musste festgehalten werden, wo im Waterjayout die Transistoren lagen, danach wurden die einzelnen dice spezifiziert und so weiter. Aufgrund der zu testenden elektronischen Bauelemente, wie Transistoren und Dioden, werden Schwellwerttests von analogen Größen, wie zum Beispiel dem Strom durchgeführt. Matrizen dienen dazu, den genauen Ort auf einem Wafer räumlich zu bestimmen, an dem angegriffen werden muss. Ein ähnliches System eines Testers ist in EP 0135 864 A2 beschrieben, der Tests von Speicherbausteinen mit AC- und DC-Tests und AC-Testmustem durchführen kann. Ein interaktives Eingabeelement nimmt die Testdaten auf und die eingegebenen Testdaten werden durch eine Vielzahl von universellen Testübersetzern, wobei jeder Testübersetzer für den zugehörigen Tester ausgelegt ist, für ihre Zielhardware übersetzt. Das beschriebene System ist also wiederum ein Tester, der aus einem Multiprozessorsystem besteht, dessen einzelne Prozessoren jeweils einzelne Testsequenzen bearbeiten.

Die für Transistoren gesuchten Verfahren finden sich in abgewandelter Form für diskrete Schaltungen zum Beispiel in der EP 0 827 608 B1 wieder. In der Absicht, eine leichtere, transparente Darstellbarkeit von Tests auf einer bestimmten Testumgebung einer diskret aufgebauten Schaltung, wie zum Beispiel einer Stromversorgung, zu realisieren, wird in der EP 0 827 608 B1 vorgeschlagen, mit einem Textdatenfeld und einem Messgerätetreiberteil zu hantieren, wobei das Textdatenfeld die Prüfanweisungen transparent und lesbar darstellt.

Betritt man das Feld der IC-Tests, so sind aus der Patentliteratur auch schon zahlreiche Ansätze bekannt.

Mit dem Ziel den einzelnen Tester zu entlasten, wird in neueren Entwicklungen, wie zum Beispiel in US 5 682 392 oder in US 6 202 183, unterbreitet, die ICs, die sowohl analoge als auch digitale Schaltkreise enthalten (mixed signals ICs), selber mit Testfunktionalität auszustatten, die über einen TAP oder ATAP (Testzugriffsport oder analoger Testzugriffsport) von einem Tester ansprechbar sind und über den TAP das Ergebnis des Tests ausgeben. Die vorgeschlagene Lösung ist bei extrem komplexen ICs angebracht, bei denen die zusätzliche Siliziumfläche, die durch die Integration der Testschaltkreise verbraucht wird, nicht ins Gewicht fällt. Bei ICs, die nur eine mittlere Komplexität aufweisen, wird hingegen Wert darauf gelegt, dass mit möglichst wenig Siliziumfläche die gesamte gewünschte Funktionalität des ICs abgedeckt wird.

Ein anderer Ansatz ist in den beiden Dokumenten US 6 353 904 und in DE 195 23 036 A1 vorgestellt. In beiden Dokumenten sollen zur Wiederverwendbarkeit von Programmsequenzen auf Testern vorbereitete Sequenzen in Bibliotheken oder Formblättern ausgelagert werden können, um anschließend bei einem neuen Testprogramm mit entsprechenden Anpassungen die einzelnen Blöcke wieder einzubinden. Der Ansatz ist dann brauchbar, wenn die elektronische Schaltungsanordnung des Testers für das neue IC in weiten Teilen identisch zu den früheren Testerkonfigurationen bleibt. Es kann nicht unter das Niveau einer Testblockzerlegung als kleinste Einheit gegangen werden. Die Zusammenstellung von Bibliotheken für eine Hochsprachenprogrammierung, die heutzutage typisch für die Programmierung von Testern ist, kann jeweils für einen einzelnen Tester durchgeführt werden. Verfügt der Testerprogrammierer über eine Vielzahl von Testern, womöglich noch von verschiedenen Testerherstellern, so ist der Ansatz der beiden Dokumente nicht erfolgversprechend.

Um den Übergang von einem IC-Design zu einem Testprogrammdesign zu vereinfachen, wird in US 6 182 258 B1 empfohlen, die Module und Chipteile, die in einer HDL-Sprache entworfen sind, durch einen Initiator für einen Simulator, der in einer Sprache wie C oder C++ geschrieben ist, auf ihre Funktionstüchtigkeit zu testen. Durch die Simulation in der Entwurfsphase können Fehler, die im Entwurf des ICs liegen, schon vermieden werden. Damit die Fehler gefunden werden können, werden zufällige Testmuster abgearbeitet. Es ist nicht notwendig, ICs erst zu produzieren, um später in einer Testphase zu bemerken, dass der Entwurf entscheidende logische Fehler aufweist.

US 6 205 407 schlägt ein Verfahren vor, mit dem die Rechenzeit und der erzeugte Datenumfang eines Testprogramms reduziert werden kann. Statt das fertige Testprogramm, das nach seinem Funktionenverlauf bzw. nach seiner Kurvenform, nach seinen Übersetzungsteilen und seinen Testerhardwaren durchlaufen wird, in einem mehrfachen Prozess mehrmals durch den Parser laufen zu lassen, werden die Muster und die Sequenzen für die Tests aus dem Testprogramm extrahiert und direkt in den Übersetzer geschickt, der die Daten an die Testerhardware überträgt. Eine über eine GUI-Schnittstelle eingegebene Testerhardwarebeschreibung kann in einem File abgelegt werden, und später für ein neues Testprogramm wieder aufgerufen und eingebunden werden. Die Entwickler des beschriebenen Verfahrens haben erkannt, dass es vorteilhaft ist, fertige Testhardwarebeschreibungen einmal anzulegen und später immer wieder verwenden zu können. Doch trotz dieser Vereinfachung ist der Übersetzer so ausgelastet, dass alle möglichen Tricks angewendet werden müssen, damit der Testvorgang in akzeptablen Zeiten durchführbar ist.

In der DE 101 01 067 A1 wird der Bedarf an universellen Programmierroutinen für Tester gesehen. Gleichzeitig wird erklärt, es wäre ein Problem, wenn die universellen Programmierroutinen, die zum Beispiel in C oder JAVA geschrieben sind, auch Elemente enthalten, die für die jeweilige Testerhardware wichtig sind. Daher soll als Lösung die universelle Testerroutine nur allgemeine Komponenten enthalten und die Routinen, die speziell für den Tester notwendig sind, durch das universelle Programm, das in einer Kernroutine genauso wie das spezielle Programm eingebunden ist, aufgerufen werden. Die Funktionsprüfung kann DC- und RF-Tests umfassen. Es kann also ein Programmierer das Testprogramm erstellen, der nicht mehr vollkommen alle Finessen der Testhardware kennen muss. Jedoch sollte er in der Lage sein, die Einsprungstellen für die einzelnen Prüfroutinen der Testerhardware zu kennen. Im Ergebnis ist in DE 101 01 067 A1 ein Verfahren beschrieben, das in der Computerwelt als Sandboxsystem oder nested routines bezeichnet wird. Nachteilig ist überdies die Tatsache, dass zwar ein Programmierer nicht mehr alle Feinheiten der Testerhardware kennen muss, aber trotz der universellen Programmiersprache wie C eine Gesamtroutine bzw. Gesamtprogramm entsteht, das zwischen speziellen Befehlen und genormten Universalbefehlen ein engmaschiges Netz bildet. Diese Vorgehensweise läßt zwar auch weniger qualifizierte Programmierer Testprogramme schreiben, das Ergebnis ihrer Arbeit ist aber nur auf einer Testerhardware einsetzbar und muss jeweils erneut auf eine andere Hardware übertragen werden.

Ein weiterer Ansatz, möglichst universelle Testprogramme zu schaffen, ist der Entwurf einer Programmiersprache wie STIL (Standard Test Interface Language), beschrieben in der Norm IEEE 1450.0 bis IEEE 1450.6, die für digitale ICs entworfen worden ist. Sie normiert die Begriffe, mit denen digitale ICs getestet werden können. Jedoch haben viele ICs inzwischen nicht mehr nur digitale Schaltungsgruppen, sondern sie haben auch einen analogen Bereich.

Es ist daher wünschenswert, ein Verfahren zu kennen, mit dessen Hilfe ICs getestet werden können, die sowohl analoge als auch digitale Schaltungsgruppen vereinigen (wahre mixed signal ICs, wie z. B. Handy-ICs oder auch SOC-ICs (System on Chip-ICs)). Mixed-Signal-ICs haben ihre ganz eigenen Anforderungen. So müssen bei solchen ICs Verstärkungen, Frequenzgänge, Phasenlagen, Wellenformen, Harmonische und Laufzeitverhalten ertestet werden. Wie aus der großen Anzahl an Testaufgaben leicht zu verstehen ist, handelt es sich um eine Aufgabe, vor der viele namhafte Tester- und Softwarehersteller bisher zurückschreckten, weil die Aufgabe als unlösbar gilt.

Weiterhin soll die Steuerung für die Tester so universell sein, dass Personen, die Testerfahrung und Programmiererfahrung haben, die Testerkonfiguration auslegen können. Hierbei soll die spezielle Programmiersprache für einen Tester nicht durch eine andere spezielle, neu geschaffene Programmiersprache ersetzt werden, sondern es ist ein Verfahren erstrebenswert, durch das Universalisten für viele verschiedene Tester von verschiedenen Testeranbietern Testersteuerungen entwerfen können, die je nach Resourcenerfordernis und Auslastung der Tester von einem Tester auf einen anderen Tester portiert werden können, ohne dass hierzu viele Mannmonate oder sogar Mannjahre aufgewendet werden müssen.

Diese und andere Vorteile werden wenigstens teilweise durch ein Verfahren nach Anspruch 1 angeboten. Geeignete Ausgestaltungsbeispiele sind in den abhängigen Ansprüchen zu finden. Das Verfahren ist auf universellen Rechnern nach Anspruch 10 einsetzbar, und kann von einem zum anderen Rechner mit einem Datenträger oder elektronisch nach Anspruch 9 übertragen werden.

Das Verfahren schafft eine IC-Tester-Steuerung, die auf beliebigen Testerfamilien und Testern wie z. B. dem M3650 von Credence-SZ Testsystemen GmbH oder dem T3340 von Advantest® Europe GmbH eingesetzt werden kann. Die Testerfamilien unterscheiden sich in ihrer Struktur, ihrem Aufbau, ihrer Bedienbarkeit, ihrer eigenen Syntax, ihren Fähigkeiten, welche Tests überhaupt ausführbar sind, etc. Als Ausgangspunkt wird eine matrizenartige Darstellung oder Anordnung der Testersteuerung gewählt, die nicht speziell für einen Tester ausgelegt ist, sondern testumgebungsunabhängig Daten über das zu testende IC, das ein analoges, ein digitales oder auch ein mixed-signal IC sein kann, zusammenstellt. Die Daten sind ablegbar oder speicherbar und stehen für die weitere Bearbeitung durch den Teststeuerungsausleger als Bibliothek, Datenbank oder an einer bestimmten Stelle in einem Rechner zur Verfügung. Die Daten können später wieder in den Rechner eingelesen und bearbeitet werden. Die Testmatrizen umfassen zahlreiche Daten, wie zum Beispiel die genaue Kontaktposition des zu testenden ICs, die Bezeichnung des ICs, die Bezeichnung der Kontakte (Pins), die Definition der Versorgungsspannungen, Angaben zu Grenzwerten von gemessenen Werten, Maßnahmen, um den Schaltkreis des ICs in einen Zustand zu bringen, dass er geprüft werden kann, und so weiter. Die Daten sind in den Testmatrizen, die Mehrdimensionalitäten aufweisen, zusammengefasst. Pro IC gibt es eine Testmatrix, die eine vollständige Beschreibung der durchzuführenden Tests in einer universellen, maschinenverständlichen Art und Weise, angibt. Je nach Umfang der gewünschten Daten kann eine Matrix sechs, acht, zehn oder sogar mehr Dimensionen aufweisen. Parallel zur Testmatrix ist auch eine Darstellungsweise in einer allgemeinen Testersprache, abgekürzt GTL, möglich. Der Nutzer kann entweder an der Matrixdarstellung arbeiten oder er kann in einem Editor in der Version des GTL arbeiten. Die jeweilige Testmatrix steht einem Codegenerator zur Verfügung. Der Codegenerator wandelt die testumgebungsunabhängigen Daten, die auch als testumgebungsunabhängige Syntax vorliegen, in eine für eine ganz bestimmte, ausgewählte und bezeichnete Testhardware um. Der Codegenerator liefert nach erfolgreicher Bearbeitung entweder eine testumgebungsabhängige Syntax, die in einer für den jeweiligen Tester eigenen Hochsprache vorliegt, oder aber eine fertig kompilierte Syntax, die auf dem jeweiligen Tester ohne jeden weiteren Umwandlungsschritt, also in einer niedrigen, maschinenlesbaren Sprache, lauffähig ist. Die Syntax ist auf ein Minimum reduziert. Alle Teile, die sich auf die generelle Steuerung des Testers beziehen, wie zum Beispiel Bildschirmsteuerungen, Selbsttests des Testers, Initialisierungsvorgänge des Testers und Kalibrierungen des Testers, liegen in einer Rahmensyntax vor, die nicht durch den Codegenerator gewandelt werden. Ein als Verbinder oder Linker bezeichneter Teil des Codegenerators greift auf die Rahmensyntax zurück, um die gewandelte, testumgebungsabhängige Syntax mit der anderen, vorhandenen Syntax zu verbinden und so daraus eine lauffähige Ablaufsteuerung und Testersteuerung zu machen.

Das Verfahren hat die Vorteile, dass die Daten der Testersteuerung, die aus zahlreichen Testanweisungen bestehen, zentral vorhanden sind. Der Testausleger, ein Universalist aus dem Bereich Elektrotechnik, Elektronik oder technische Informatik mit Kenntnissen sowohl im Bereich des IC-Tests als auch mit Kenntnissen über die Möglichkeiten, was getestet werden kann, kann sich in Matrizenform alle Daten vergegenwärtigen. Die Daten können immer wieder aufgerufen, abgelegt, gespeichert und bearbeitet werden. Stellt sich im Laufe der Zeit heraus, dass ein Teil des Tests noch nicht alle gewünschten Eigenschaften eines ICs überprüfen kann oder alle Ausfallmöglichkeiten ausschließt, so können leicht weitere Testverfahren und Einzeltests in die Matrizenform eingebunden werden. Wird nach einem erfolgreichen Test eines IC-Typs ein ähnliches IC zu einem späteren Zeitpunkt wieder zu einem anderen Test in die Testumgebung gegeben, so kann die frühere Matrix erneut verwendet werden. Der Testausleger überprüft noch einmal die gewünschten Tests und macht gegebenenfalls kleine Anpassungen bzw. erweitert den Testumfang mit neuen, zwischenzeitlich gewonnenen Erkenntnissen. Durch eine simple Auswahl, auf welcher Testerhardware der IC-Test später durchgeführt werden soll, wandelt der Codegenerator die IC-Tester-Steuerung von der testumgebungsunabhängigen Zusammenstellung der eigentlichen Tests in die für den entsprechenden Tester eigene Syntax und Befehlsfolge um. Stellt sich später heraus, dass ein anderer Tester geeigneter ist oder dass er statt des geplanten Testers zur Verfügung steht, so ist für den Codegenerator nur noch die neue Testumgebung auszuwählen, keine weiteren Schritte sind notwendig, als den Wandlungsvorgang bzw. die Wandlungsphase zu starten und das Ergebnis auf der entsprechenden Testumgebung einzusetzen.

Die Testumgebung selber setzt sich aus der Testerhardware, die von dem Anbieter der Testerhardware stammt, und für den einzelnen Test speziell angepassten Lastplatinen zusammen. Der Codegenerator kann während der Wandlungsphase auf Bibliotheken zurückgreifen, die unter anderem Informationen zu den Lastplatinen und der Testumgebung beinhalten. Weil der eine Tester nur eine gewisse Anzahl an Spannungsquellen, dafür aber eine größere Anzahl an Stromquellen bietet, der andere Tester an Stelle der vielen Stromquellen auch noch Frequenzgeneratoren offeriert, müssen in einer Bibliothek Informationen bezüglich der maximal zur Verfügung stehenden Resourcen an Strom-, Spannungsquellen oder anderen Quellen und Messaufnehmern für jede Testumgebung stehen. Ebenfalls müssen in einer Bibliothek die Konvertierungen der Signale von z. B. einem Spannungssignal auf ein Stromsignal gespeichert sein. Die Beschaltung der Lastplatine und das Layout der Lastplatine hat Einfluss auf die Impedanz, das Frequenzverhalten und die Signalgeschwindigkeit des Kanals, der für ein Signal gewählt ist. Die Informationen bezüglich einer Lastplatine sind in einer Bibliothek dem Codegenerator zur Verfügung zu stellen.

Bei manchen ICs, insbesondere ICs, die mit dem Kürzel MIL versehen werden, ist es wichtig, dass auch in Temperaturbereichen von 150 °C, wenn nicht sogar bis zu 175 °C, getestet wird. Aufgeheizte ICs brauchen eine entsprechende Abkühlphase, bis sie wieder unter normalen Umgebungstemperaturen getestet werden können. Um die Testzeiten zu verkürzen, ist es wichtig, auf solche Details zu achten. Daher soll der Codegenerator auch auf Bibliotheken zurückgreifen können, in denen Reihenfolgen von Testverfahren überwacht werden und, wenn erwünscht, optimiert und verkürzt werden können. Manchmal kann es vorteilhaft sein, die einzelnen Optimierungen in verschiedene Bibliotheken aufzuteilen, in anderen Fällen kann es vorteilhaft sein, Codegeneratoroptimierungen, Testumgebungsresourcen, Reihenfolgen von Testverfahren und andere Informationen in einer Bibliothek zusammenzufassen. Insgesamt muss es eine Bibliothek oder mehrere Bibliotheken geben, die vom Codegenerator verstanden werden können, und Informationen zu einem oder mehreren der folgenden Dinge aufweisen: die Testumgebung, die testumgebungsabhängige Syntax, die Testumgebungsresourcen, die Reihenfolge von Testverfahren, die Standardfunktionen der Testumgebung, die Lastplatinenstruktur, die lastplatinenabhängigen Standardfunktionen und die Codegeneratoroptimierung. Als Standardfunktionen werden die Befehle, Steuerungen und Anweisungen bezeichnet, hinter denen sich wieder eine Anzahl von einzelnen Steuerungen zusammenfassend verbergen, wie zum Beispiel Aufwachfunktion, Temperaturtest oder Eingangstest. Als Alternative ist es auch gelegentlich empfehlenswert, eine Bibliothekenschnittstelle vorzusehen, die Bibliotheken einer dritten Partei, wie zum Beispiel eines Nutzers des Verfahrens, zur Verfügung stellt.

Die mehrdimensionale Testmatrix vereint zahlreiche Informationen in verschiedenen Dimensionen. In einer ersten Dimension, die wahlweise horizontal oder vertikal angeordnet sein kann, werden die Kontakte eines ICs in ihrer Anzahl und in ihrer Anordnung aufgelistet. In einer überlagerten Dimension, die auf einer anderen Ebene als die Ebene liegt, die die Informationen über die Anzahl und die Anordnung der Kontakte untereinander eines ICs angibt, werden die Bedeutung der Kontakte, ihr jeweiliger Name und die Signalflussrichtung pro Kontakt angegeben. In anderen Dimensionen der Testmatrix können Testanweisungen, Testanweisungsoberbegriffe und Prüfmuster festgelegt werden. Wenn zum Beispiel bei verschiedenen Temperaturen getestet werden soll, so müssen in einer weiteren Dimension die Testrahmenbedingungen angegeben werden. Ebenso kann der maximale und minimale Versorgungsstrom eine Testrahmenbedingung sein. Die Geschwindigkeit, innerhalb der das IC reagiert und den gewünschten Messwert ausgibt, oder auch der tatsächliche Versorgungsstrom des ICs kann als Bedingung für eine Gütesortierung in einer Dimension angegeben werden, die mittels Schaltwerten in unterschiedliche Güteklassen, die den Vorschriften nach CECC 90000 und CECC 90200 entsprechen, einsortiert wird (binning). Um konkrete Schalthysteresen, Pegel und Schaltbedingungen festzulegen, sind in einer oder mehreren Dimensionen Schaltwerte festzulegen. Für ein besseres Verständnis der Testumfänge, der Bedeutung der Testrahmenbedingungen und der Absichten bzw. Zweck der angegebenen Tests sind an einer Dimension der Matrix Angaben zur funktionalen Beschreibung der Tests vorgesehen.

Der Codegenerator benötigt je nachdem, für welche IC-Typen er eingesetzt werden soll, unterschiedliche Generatoren und Module. Wenn alle Module und Generatoren benötigt werden, so umfasst der Generator einen DC-Testgenerator, einen AC-Testgenerator, einen Digital-Testgenerator, einen Lastplatinengenerator und einen Testregelverifizierer. Der Generator durchläuft mehrfach die Matrizen. In einer ersten Stufe werden die Matrizen in einer für den Codegenerator verarbeitbaren Version aufbereitet. Aus dieser Version werden die Daten und Steueranweisungen extrahiert, die durch einen der Testgeneratoren bearbeitbar sind. Danach werden die Daten und Steueranweisungen extrahiert, die durch einen anderen Testgenerator bearbeitbar sind. Als ein weiterer Schritt wird überprüft, ob alle Testregeln bearbeitbar sind und ob die Resourcen bezüglich der Testumgebung, des Testers und der Lastplatine umzusetzen sind. Abschließend wird nach einem Kriterium oder mehreren Kriterien optimiert, günstige Kriterien sind Laufzeitoptimierungen, günstige Testablaufbedingungen und günstige Resourcenplanung.

Der Digital-Testgenerator erstellt Programmsegmente, indem er die Vektorentabelle der Testdaten einliest und die Pegel für die digitalen Kontakte in Bezug auf die Treiber, die Komparatoren und die Lasten einstellt. Weitere Aufgaben, die der Digitaltestgenerator wahrnimmt, ist die Start- und Stoppaddresse der Vektorentabelle zu bestimmen, die erwarteten Reaktionen bei der Testauswertung festzulegen und Kurvenformen und Zeitbedingungen einzustellen. Hilfreich für die Erstellung der Vektorentabelle ist die Berücksichtigung von Zustandstabellen der Eingangskontakte und der Ausgangskontakte und die Beschreibung des zeitlichen Verlaufs der Eingangs- und Ausgangszustände. Hierfür müssen die Kurvenformen festgelegt werden.

Der DC-Testgenerator schafft Programmsegmente auf Grundlage der Matrizenvorlagen mit den Testdaten und den Steueranweisungen. Er benutzt die entsprechenden Teile oder Dimensionen der Matrizenvorlagen, um die für die Tests notwendigen Startbedingungen festzulegen. Danach werden die geeigneten Stimuli, wie zum Beispiel, welcher Strom oder welche Spannung in Bezug auf Betrag, Vorzeichen, Genauigkeit und Auflösung erwünscht ist, erzeugt, um diese an den ausgewählten Kontakten des ICs anzulegen. Danach wird bestimmt, welche Messung zu den Stimuli korrespondiert und wo das Messergebnis abzulegen ist, das heißt, wie das Resulthandling aussieht. Wenn der Testablauf für einen Stimuli festgelegt ist, müssen die Einstellungen zurückgesetzt werden, um danach in einem weiteren Schritt für die nächste Steueranweisung aus einer Matrix die gleichen Übersetzungs-oder Wandlungsschritte durchzuführen.

Der AC-Testgenerator hat die Aufgabe, aus der testumgebungsunabhängigen Testbeschreibung von Tests mit ändernden Signalverläufen die Stimuli in Bezug auf den geeigneten Kontakt am IC, die gewünschte Kurvenform, die Frequenz des Signals des Stimulus und die Genauigkeit zu extrahieren. Ähnliche Angaben müssen in den Matrizen in Bezug auf die Kurvenform, die Frequenz, die Amplitude und den Kontakt am IC des zu erfassenden Signals festgelegt werden. Nachdem der Stimulus seiner Art nach festgelegt worden ist, muss in dem Programmsegment sichergestellt sein, dass die jeweiligen Stimuli synchron angelegt worden sind. Mittels DSP-Berechnungen, d. h. Digitalsignalprozessorberechnungen, sind die einzelnen Parameter, wie zum Beispiel die Verstärkung, der Signal-Rausch-Abstand und so weiter, zu ermitteln. Das Messergebnis ist auszuwerten und gegebenenfalls bei einem Güteklassensortierverfahren (binning) in seine entsprechende Klasse einzusortieren. Um die einzelnen Stimuli einstellen zu können, ist zwischen jedem Stimulus oder jeder Stimuligruppe, das sind die Stimuli, die gleichzeitig an verschiedenen IC-Kontakten anzuliegen haben, die Einstellung des Testers, der Lastplatine oder der gesamten Testumgebung in einen neutralen Ausgangszustand, einen so genannten Resetzustand zu versetzen, bevor weitere Stimuli anzulegen sind.

Der Lastplatinengenerator hat die Aufgabe, die Verbindung zwischen dem Kopf des Testers, das Bauteil, das den elektrischen Zugang zu dem Tester ermöglicht, und dem IC herzustellen. Die für den Lastplatinengenerator korrespondierende Bibliothek hat die Daten aller Lastplatinen (Loadboards) zusammengestellt, die schon vorhanden sind. Daher ist es eine Aufgabe des Lastplatinengenerators zu überprüfen, ob die benötigte Platine schon existent ist. Hierbei wird gleichzeitig ein Abgleich durchgeführt, ob nicht eine andere, schon existente Platine die Anforderungen an alle Lastplatinen erfüllt. Falls der Fundus der existenten Lastplatinen nicht ausreichend ist, ermittelt der Lastplatinengenerator, ob nicht durch geringen Aufwand eine bestehende Lastplatine für die neue Aufgabe anzupassen ist. Besonders vorteilhaft ist es, wenn der Lastplatinengenerator mit Ausgabeformaten von Standardlayoutprogrammen und Standardelektroniksimulationsprogrammen wie zum Beispiel Protel® von Altium, Orcad® von Cedence Design System, Eagle® von Cadsoft oder P-SPICE® arbeiten kann. Falls keine geeignete Lastplatine aus einem existierenden Fundus vorrätig ist oder anpassbar ist, so werden entsprechende Teilelisten oder Netzplanlisten für die Schnittstellen zum IC und zum Kopf des Testers hin entworfen, die die zu bearbeitende Lastplatinenschaltung als noch zu definierende Box anzeigen, so dass der Tester und Entwickler weiß, dass als Verbindung zwischen dem Kopf des Testers und dem Kontakt des ICs eine Lastplatine zu entwerfen ist.

Das Verfahren umfasst Testmethoden, die in den mehrdimensionalen Testmatrizen als einzelne Testmethoden auflistbar sind. Die Testmethoden, die speziell für mixed-signal-ICs entwickelt worden sind, lassen sowohl digitale als auch analoge Signale an der Steuerung der Testumgebung zeitlich synchron auftreten. Erst durch die zeitliche Synchronität, das bedeutet, dass an einem analogen Pin des ICs ein entsprechendes analoges Signal anliegt und genau zur gleichen Zeit an einem digitalen Pin des ICs ein entsprechendes digitales Signal anliegt, kann auch tatsächlich die volle Funktionalität eines mixed-signal-ICs getestet werden.
Aber das Verfahren bietet nach einem anderen Aspekt der Erfindung auch, dass die Signale, die analoge und/oder digitale Signale sind, von der Testumgebung, vorzugsweise zeitversetzt nach dem Einprägen von Signalen der Steuerung, eingelesen werden, um über mixed-signal-Testmethoden, wie z. B. eine Methode, die die einzelne oder mehrere Verstärkungen misst, die die Spannungsverhältnisse misst, die die Frequenzgänge der Signale misst, die die Phasenlagen der Signale zueinander misst, die die Wellenformen der Signale, oder die die Harmonischen, vor allem mittels der Fourieranalyse, und/oder die Laufzeitverhalten misst, ausgewertet zu werden. Somit können nicht nur mixed-signal-Signale auf das zu testende IC gegeben werden, sondern es werden auch nach mixed-signal-Methoden die Antworten des zu testenden ICs analysiert.
Das Verfahren kann als Software verkörpert werden und auf Datenträgern abgelegt werden. Das Verfahren ist auf Rechnern mit einem oder mehreren Prozessoren unter allen gängigen Betriebssystemen wie Linux, Unix oder auch Windows lauffähig.

Die Erfindung kann anhand der folgenden Figuren noch besser verstanden werden, wobei
Fig. 1 das Verfahren als ein erstes Blockablaufdiagramm darstellt,
Fig. 2 die architektonische Einbindung der generierten Syntax in die Rahmensyntax darstellt,
Fig. 3 eine erste Testmatrix für einen Analog-Digital-Test darstellt,
Fig. 4 eine weitere Testmatrix für einen Analog-Test darstellt,
Fig. 5 eine zusammengeklappte Testmatrix, deren erste Reihe teilweise aufgeklappt ist, darstellt,
Fig. 6 das Verfahren in einer weiteren Ausführungsform darstellt, und
Fig. 7 eine schematische Darstellung einer mixed-signal-Testanordnung mit Testobjekt darstellt.

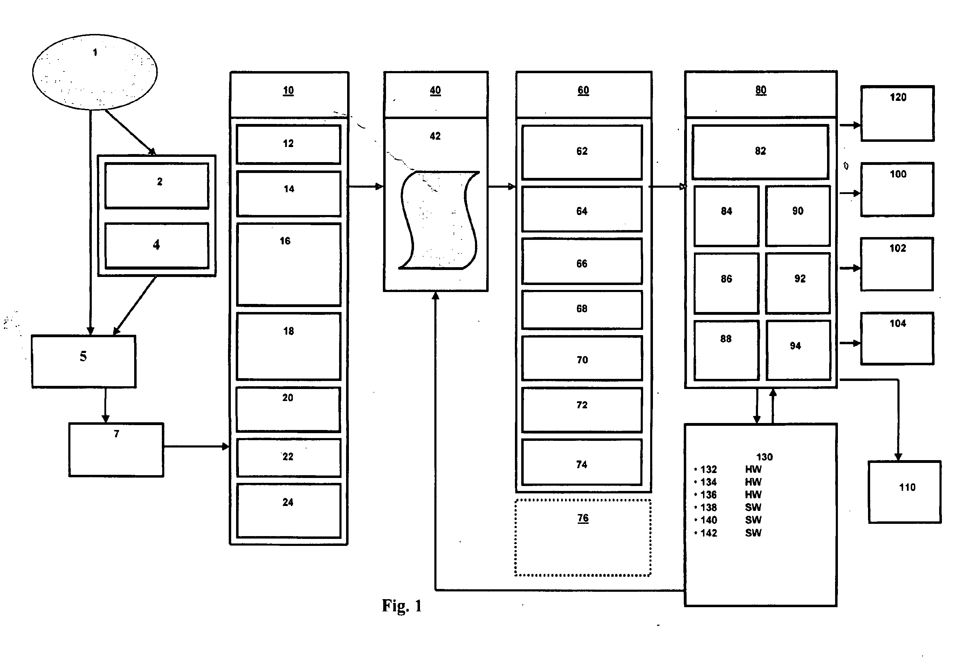

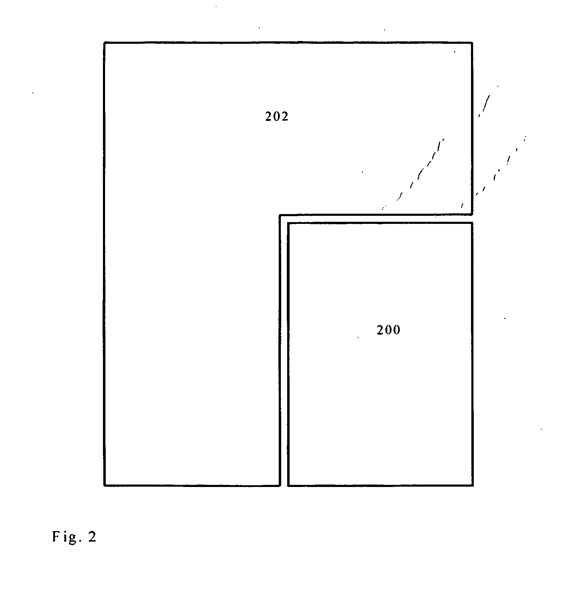

Fig. 1 stellt das Verfahren als ein erstes Blockablaufdiagramm dar. Die Kästchen 1, 5 und 7 stellen Schnittstellen zum Lieferanten des zu testenden ICs dar. Der Lieferant eines ICs kann in jedem Stadium seiner Entwicklung 1, also schon zum Zeitpunkt der Idee der Entwicklung wie auch mit dem fertigen Halbleiter-IC, einen Test nach dem erfindungsgemäßen Verfahren vorsehen. Nach einer ersten summarischen Prüfung 2 und 4, die optional vorgesehen ist, kann ermittelt werden, ob die gewünschte Überprüfung des ICs überhaupt machbar ist 5. Die summarische Prüfung 2 und 4 umfasst die Prüfung der Testbarkeit 2 und der Vorschlag der eigentlichen Teststrategie 4. Zur Teststrategie 4 gehören solche Entscheidungen, wie zum Beispiel, benötigt das sicherheitskritische IC eine vollständige Testabdeckung, auch als 100 % Funktionalitätstest bezeichnet, werden nur kritische Betriebsparameter getestet oder auch der Bereich des normalen Dauerbetriebs. Die Konzeption des Halbleiterschaltkreises 7, die dann irgendwann als IC vorliegt, kann über unterschiedliche Daten als Eingangsdaten bzw. Vorlage 10 vorliegen. Eine gängige Variante ist das Datenblatt des ICs 12. Eine andere Vorlage 10 ist eine Beschreibung der Anwendung 14 des ICs. Ausgehend von einer allgemeinen Beschreibung der Anwendung 14 kann auch anhand von Datenbanken oder anderen spezifischen Wissensbasen ein individueller Test für einen bestimmten Typ eines ICs vorgesehen sein 16. Anzuführen wäre als Ausführungsbeispiel ein umfassender Frequenztest bei jedem Typ eines Verstärkers. Eine weitere Datenquelle oder Vorlage 10 sind die Beschreibungen des Halbleiterschaltkreises in einer allgemein gültigen, maschinenverständlichen Sprache wie VHDL 18. Andere Vorlagen sind Hinweise auf besonders kritische Punkte im Entwurf 20, von Standard- oder besonderen Testmustern 22, in der Fachwelt als Testpattern bezeichnet, oder einer Design- oder Entwurfsspezifikation 24. Aus dieser Vorlage 10 auf der einen Seite und aus dem Ergebnis des Codegenerators 80 oder auf Grundlage der Bibliotheken 130 auf der anderen Seite wird die Testspezifikation 42 als Pflichtenheft oder als Dokumentation 40 automatisch mittels hinterlegter und automatisch zusammenstellbarer Textbestandteile in für den Nutzer verständlicher Weise geschrieben und zur Verfügung gestellt. Die Testspezifikation 42 kann auf einen Computer, Drucker oder Datenspeicher ausgegeben werden. Statt von der Testspezifikation 42 und der Vorlage 10 als Ausgangspunkt zu starten, kann auch mit der testerunabhängigen Testbeschreibung in maschinenverständlicher Art und Weise 60 begonnen werden. Die testerunabhängige Testbeschreibung liegt günstiger Weise als eine oder mehrere mehrdimensionale Matrizen vor, die über eine graphische, tabellarische oder Editorschnittstelle von außen beeinflussbar ist. In der testerunabhängigen Testbeschreibung 60 liegen die Daten, Steueranweisungen und Informationen wie die Testbedingungen 62, also die Anzahl der Kontakte, die Bezeichnung der Kontakte, die Definitionen der Versorgungsspannungen, die Definitionen der Spannungen an den Eingängen des zu testenden ICs, die Grenzwerte 64, also die Angabe über die Grenzen der zu messenden Signale, die Vektoren 66, also die Zusammenstellung der Testvektoren, die Testvorbereitungen 68, die Ablaufsteuerungsbefehle und Ablaufsteueurungsbefehlsfolgen 70, die Zusammenstellung der Testumfänge 72, und die Funktionstestaufrufe 74 von Standardfunktionen der Bibliotheken 130 vor. Die testerunabhängige Testbeschreibung 60 steht dem Codegenerator 80 zur Verfügung, der mit einzelnen Erzeugern, Generatoren, Analysierern, Parsern und Linkern unter Rückgriff auf die Bibliotheken 130 die testumgebungsabhängige Ablaufsteuerung generiert, die entweder auf dem einen 100 oder dem anderen Tester 102, 104 lauffähig ist. Als Alternativen können anstelle von lauffähigen Ablaufsteuerungen auch einzelne Lastplatinenbeschreibungen 110 oder spezielle testerabhängige Vorlagen 120 generiert werden. Die testerunabhängige Testbeschreibung 60 kann als maschinenlesbare Variante entweder als Matrix oder in einer allgemeinen Testersprache 76 vorliegen. Der Codegenerator 80 verarbeitet die gespeicherten Informationen aus der Testmatrix 60. Das Ergebnis der Bearbeitung ist eine spezifische Ablaufsteuerung für den ausgewählten Tester 100, 102, 104. Diese Ablaufsteuerung wird wie in Fig. 2 dargestellt aus den Informationen der Rahmensyntax 202 und den Informationen der testumgebungsabhängigen Syntax 200 erzeugt. Der Codegenerator 80 greift auf weitere Prozeduren und Verfahren der Halbleiterschaltkreise und der relevanten Tester 100, 102, 104 zurück. Diese sind in einer der Bibliotheken 130 gespeichert. Der Codegenerator 80 besitzt eine Ablaufsteuerung 82, welche den Wandlungsprozess kontrolliert. Im DC-Testgenerator 84 werden die DC-Tests aus den Informationen der testumgebungsunabhängigen Testbeschreibung 60 und den Bibliotheken 130 erstellt. Im AC-Testgenerator 86 werden die AC-Tests aus den Informationen der testumgebungsunabhängigen Testbeschreibung 80 und den Bibliotheken 130 erstellt. Im Digitaltestgenerator 88 werden die Digitaltests aus den Informationen der testumgebungsunabhängigen Testbeschreibungen 60 und der Bibliotheken 130 erstellt. Im Lastplatinengenerator 92 wird die Zusatzbeschaltung für die Lastplatine generiert. Mit dem Regelprüfer 90 kann die testumgebungsabhängige Syntax nach bestimmten Regeln abgeprüft werden. Mit dem Optimierer 94 kann die Syntax auf bestimmte Anforderungen hin optimiert werden (z. B. Testzeit, Genauigkeit der Messergebnisse usw.).

Die Bibliotheken 130 können in Bibliotheken für Testerresourcen 132, in Bibliotheken für Lastplatinenbeschreibung 134, in Bibliotheken für Lastplatinenstandardfunktionen 136, Testerstandardfunktionen 138, Teststandardfunktionen 140 und IC-abhängige typische Standardfunktionen 142 aufgeteilt werden. Die folgende Zusammenstellung ist nur beispielhaft. Die Angabe HW oder SW zeigt an, ob die jeweilige Bibliothek 130 eher Software(SW)- oder Hardware(HW)beschreibungen umfasst. Die Testerresourcenbibliothek 132 kann zum Beispiel Daten über die Anzahl der möglichen Kanäle, die Angaben über die Zeitmesseinrichtungen, die Angaben über die Stromversorgungen, die Angaben über die Verschaltungsmöglichkeiten der Signale, die Angaben über das Zeitverhalten der zu treibenden Signale und die Angaben über die Messeinrichtungen in den verschiedenen Testern 100, 102, 104 und Testumgebungen enthalten. In der Lastplatinenbeschreibungsbibliothek 134 können Angaben über die Verdrahtung und die Beschaltung der Lastplatinen stehen. In der Bibliothek zur Testumgebungsstandardfunktion 138 sind solche Steueranweisungen wie das Einprägen des Stroms und die zu erwartende Spannung, Angaben über die Messung der Versorgungsspannung, Angaben zum Durchführen der Zeitmessung an einem oder an mehreren Kanälen, oder das umfassende Testen von Parametern des Halbleiterschaltkreises enthält. Der Codegenerator 80 greift auf die Daten der testumgebungsunabhängigen Testbeschreibung 60 in Matrizenform 76 oder in einer allgemeinen Testersprache zurück und durchläuft mit der Ablaufsteuerung 82 in verschiedenen Schritten die Matrix 76 und generiert einen Teil der Syntax 200 nach Fig. 2, die in die Rahmensyntax 202 eingebunden wird. Im folgenden sei beispielhaft eine allgemeine Testersprache, eine GTL, aufgerührt:
- *Pin_Zuordnung:*: Pin1 =CLK;
Pin2=Urefl ;
Pin3=Reset;
...
Pin41=VCC1;
Pin42=AGND;
Pin43=GND;
Pin44=U+;
- *Pin_Function:*: Pin1=Input;
Pin2=Input;
Pin3=Input;
...
Pin41=Power;
Pin42=PWD;
Pin43=GND;
Pin44=Output;
- *Settings:*: VIL1=0,1V;
VIL2=0,4V;
VCC1=5,0V;
- *Limits:*: LoLim1=0,1V;
HiLim=1,2V;
- *MeasCond:*: CurrentSourel (Force=10mA, Measure=voltage, Range=2V, Clamp=5V);
- *Setup:*:
- {: Setup_Cond_No=1;
Pin1=NC
Pin2=NC
Pin3=NC
...
Pin41=Power;Pin42=PWD;
Pin43=GND;
Setup_Cond_No=2 ;
Pin1=VIH1
Pin2=VIH1
Pin3=VIH1
...
Pin41=Power;
Pin42=PWD;
Pin43=GND;
Setup_Cond_No=3;
Pin1=VIL1
Pin2=VIL1
Pin3=VIL1
...
Pin41=Power;
Pin42=PWD;
Pin43=GND;
- }:
- *Sequencer_Step:*:
- {: Test_No=1
Test_N ame=Continuity;
Pinl=VIL1
Pin2=VIL2
Pin3=VIL1
...
Pin41=Power;
Pin42=PWD;
Pin43=GND;
Pin44=Measure(Messwert_Test_No1, LoLim1, HiLim2,Pass-Bin, Fail-Bin);
- }:
- *Sequencer:*:
- {: Do_Test_No1;
Do_Test_No2;
Delay_2ms;
Do_Test_No3;
Do_Test No4;
Make_Binning
- }:

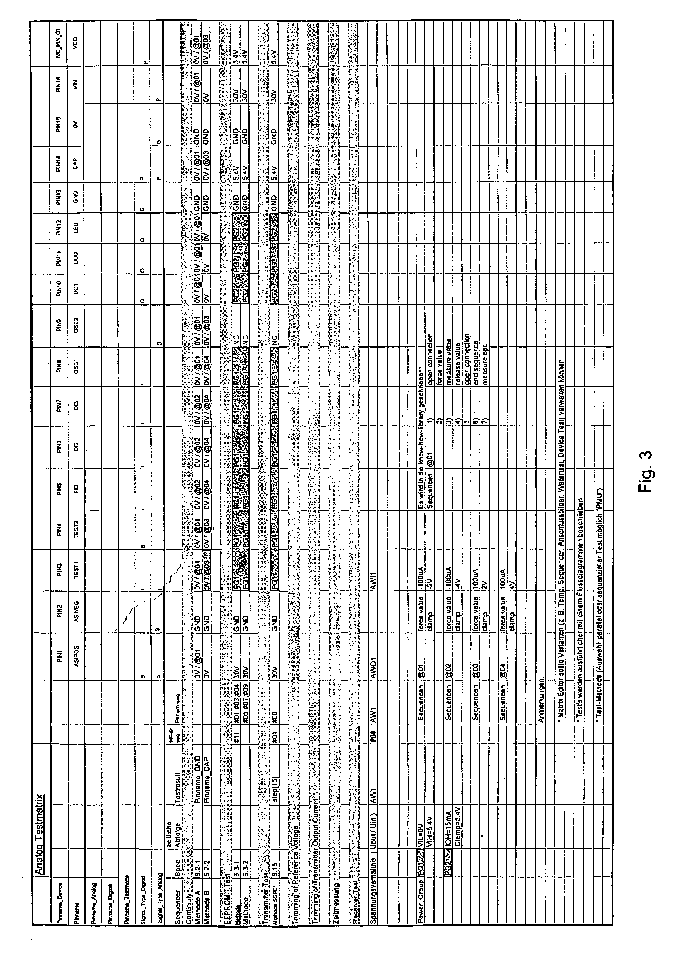

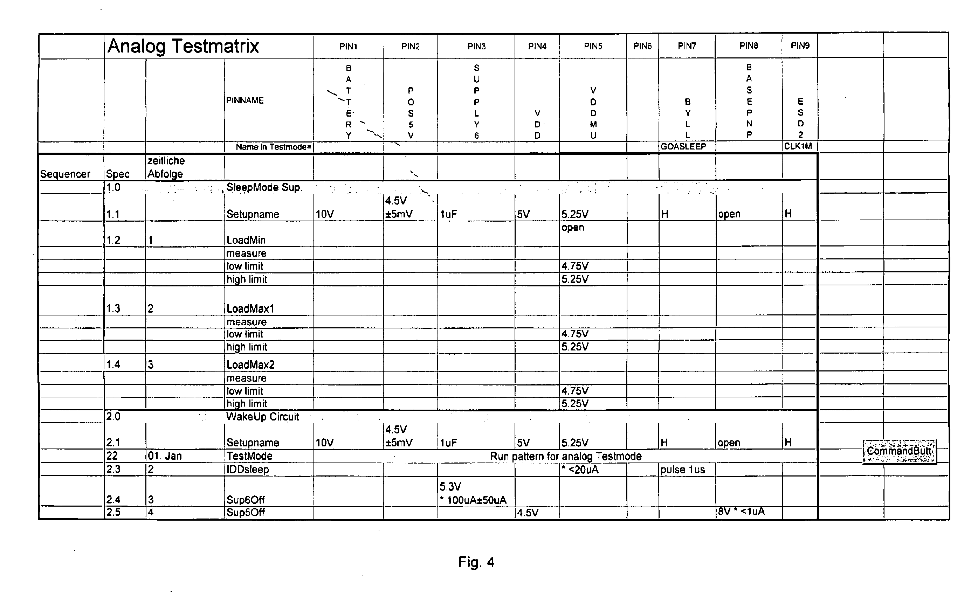

Es ist zu erkennen, dass solche allgemeinen testerunabhängigen Ablaufsteuerungen viele Zeilen und Seiten umspannen können, der Nutzer schnell die Übersicht verliert und nur ein Nutzer, der alle Ablaufsteuerungen systematisch bearbeitet, auch sinnvolle Tests gestalten kann. Daher kann es in manchen Situationen sinnvoller sein, die Testmatrix wie in Fig. 3, Fig. 4 oder Fig. 5 zu gestalten, um mit einen Blick den Überblick für die wesentlichen Steuerungsgruppen und Anweisungen zu bewahren. Fig. 3 und Fig. 4 stellen zwei kurze, übersichtliche Tests für zwei unterschiedliche ICs, einmal mit 16 Kontakten und einmal mit 8 Kontakten dar. Sie sind in einer Sprache abgefasst, die jedem Elektroniker und insbesondere jeder mit dem IC-Test vertrauten Person, bei einfachem Lesen eingängig und geläufig ist. Es handelt sich also um eine assoziativen Sprache. Fig. 3 zeigt in der Mitte der Matrix umfassende Tests, die nur unter Oberbegriffen zusammengefasst sind, die aber nicht weiter aufgeschlüsselt werden, sofern nicht der Test mit dem Titel "Zeitmessung" oder mit dem Titel "Trimming of Reference Voltage" weiter ausgeklappt wird, um die dahinter liegenden Ebenen und Dimensionen zu sehen. An der untersten Stelle der Matrix können Kommentare platziert werden. Alle Zeilen zum Kontaktnamen sind ausgeklappt. Die einzelnen Zeilen beinhalten solche Informationen wie zum Beispiel Kontaktnummer, Kontaktname, Kontaktrichtung, Kontakttyp usw. Die in Fig. 3 dargestellt Matrix ist eine Testmatrix, die als Eingabemaske wiedergegeben ist. Sie bezieht sich auf einen besonderen IC, der von einem IC-Entwickler als spezieller ASIC mit einem analogen und einem digitalen Anteil entworfen worden ist, die untereinander in Beziehung stehen. Das Beispiel-IC ist mit 16 Pins ausgestattet, jedem Pin ist in den ersten Zeilen ein Name zugeordnet, der gleichzeitig dem Nutzer eine gewisse Bedeutung des Pins verdeutlicht. In weiteren Zeilen ist aufgeschlüsselt, was ein digitaler Pin und was ein analoger Pin ist. Daneben enthält die jeweilige Zeile Angaben, ob es sich um einen Eingabepin (I), einen Ausgabepin (O), einen bidirektionalen Pin (O), einen Portpin (P) oder einen Massepin (G) handelt. Daneben sind noch weitere Kodierungen vorstellbar, die andere Pinbedeutungen haben, wie zum Beispiel die Aufschlüsselung von ganzen Bussystemen. Die hinterlegten Zeilen geben Titel der einzelnen Tests wieder, hinter denen sich, wie zum Beispiel bei dem Continuity-Test, dem EEPROM-Test oder dem Transmitter Test aufgeklappt verdeutlicht, weitere Testmethoden befinden, die den gesamten Test ausmachen. Über den Befehl "Sequencer" aus der GTL wird die zeitliche Abfolge der Tests bestimmt. Aus den Zeilen ist zu entnehmen, dass auf die analogen und auf die digitalen Pins analogähnliche Testsignale gegeben werden sollen. Wie zum Beispiel unter dem EEPROM Test gezeigt, können die einzelnen Methoden einen Verweis auf tiefer liegende Matrizen haben. Die Signale werden zeitlich besonders gestaffelt in Form von Testmustern (Pattemseq) nach und nach auf Pins gelegt. Ausgewählte Spannungswerte, Stromwerte oder Abläufe von gleichzeitig eingeprägten Strömen bei bestimmten Spannungswerten werden je nach Test auf den einzelnen Pin gelegt. Durch die Kommentierungen im unteren Bereich der Matrizen werden besondere Abläufe bestimmt (Sequencen), Spannungswechsel (Power_Group), welche Testfolgen in einer besonderen Bibliothek, vorzugsweise automatisch, hinterlegt werden sollen und welche Besonderheiten bei der entsprechenden Testmatrix für den Benutzer noch vorhanden sind.

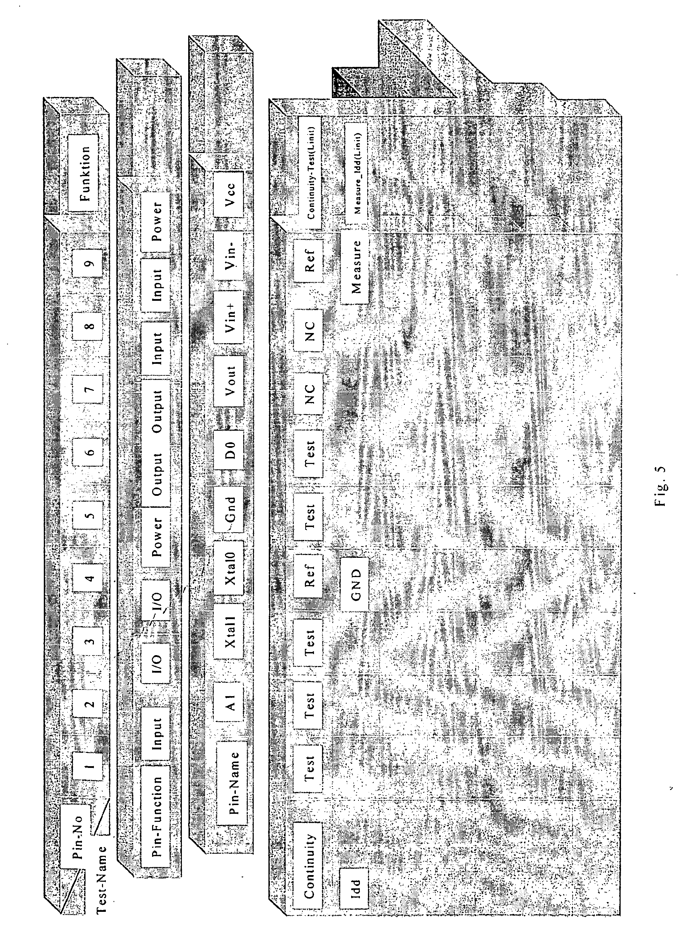

In Fig. 4 sind die beiden Tests mit den Titeln "SleepModeSup." und "WakeUpCircuit" als 1.0 und 2.0 durchnummeriert. Die Bedeutung jedes einzelnen Tests ist durch Ausklappen aufgeschlüsselt, wobei die Nummerierung weiter unterteilt ist. Der Benutzer kann einzelne Werte in den Tests anpassen. Es reicht aber auch für den Codegenerator 80 aus, wenn nur die Titel angegeben werden. Die Matrix nach Fig. 5 verschachtelt die einzelnen Ebenen. Die Ebene der ersten Tiefe ist ausgeklappt. Die Kontakte, als Pin bezeichnet, sind in Bezug auf das Ausklappen aufgeschlüsselt. Die beiden aufgelisteten Tests sind der Test mit dem Titel "Continuity" und der Test mit dem Titel "Idd". Beides sind spezielle Tests, die von den Erfindern des Verfahrens stammen. Es sind Tests, die im Falle des Continuity-Tests ein erster Test für ICs sind, mit denen sichergestellt wird, ob alle Kontakte Verbindung mit dem Kopf des Testers haben. Der Test "Idd" misst den Stromfluss zwischen unterschiedlichen Kontakten.

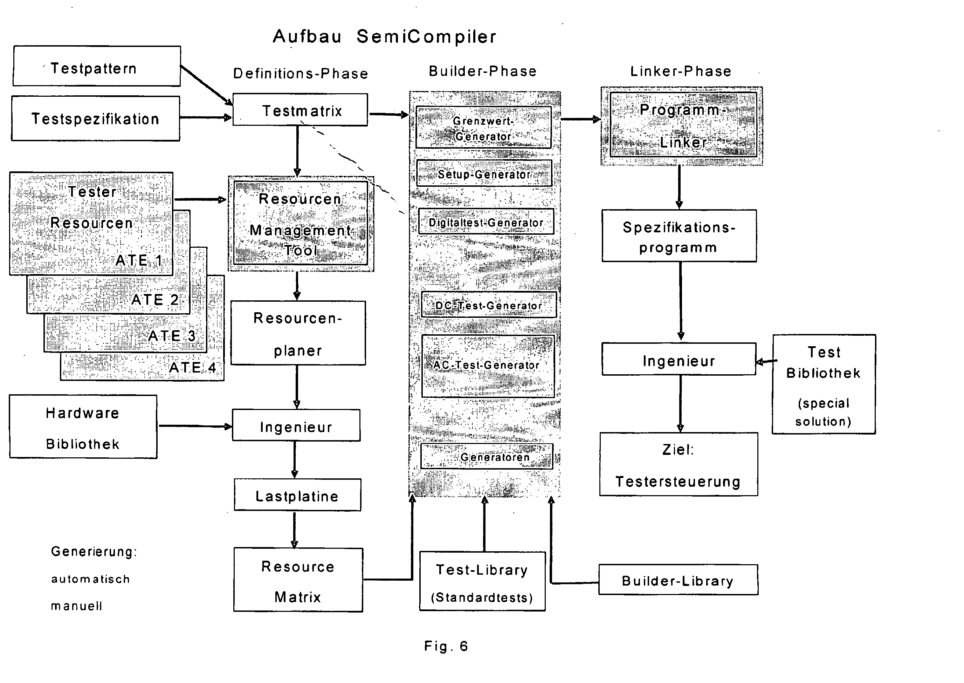

In dem Ablaufdiagramm nach Fig. 6 ist das erfindungsgemäße Verfahren mit einigen Änderungen gegenüber dem Ausführungsbeispiel nach Fig. 1 dargestellt. Die unterlegten Blöcke umfassen den automatisierten Teil des Verfahrens. In der Builderphase werden die einzelnen Generatoren angestoßen und die Daten werden aus der Testmatrix extrahiert. Wenn alle Builderstufen durchlaufen sind, wird der Linker in der Linkerphase gestartet, der die endgültige Syntax per Linken erstellt. Der Builder greift auf die diversen Bibliotheken zurück, auf die ein Nutzer, hier ein Ingenieur, Einfluss nehmen kann. Das Resourcenmanagementtool überprüft vorab, ob ein Generieren und Zusammenbinden der generierten Syntaxteile in eine Gesamtsyntax überhaupt möglich sind. Hierzu kennt das Resourcenmanagementtool die Zusammenstellungen und Möglichkeiten der Tester und Testumgebungen.

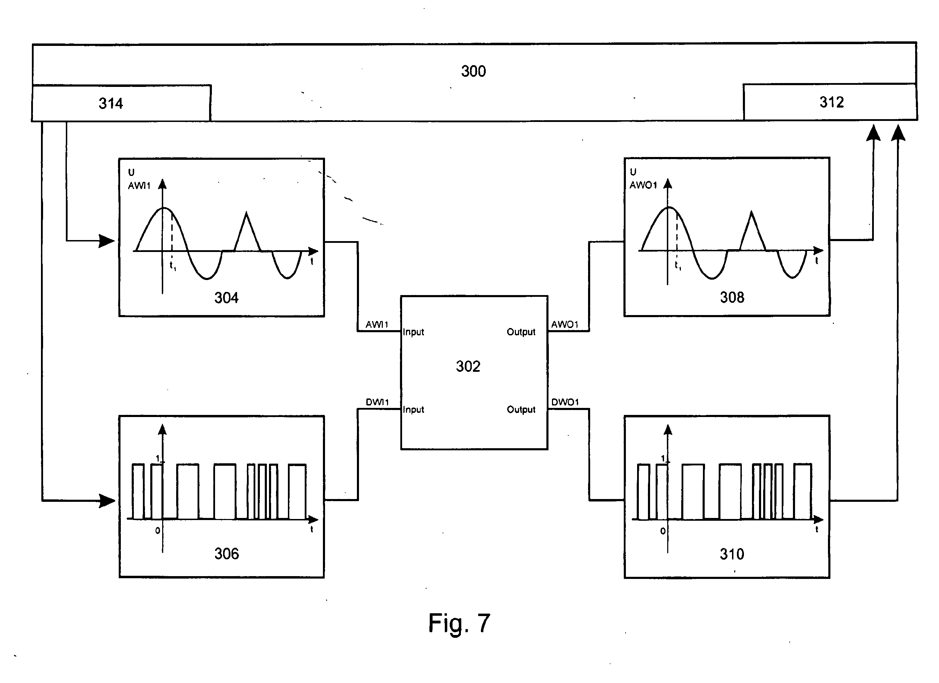

In Fig. 7 wird schematisch eine bestimmte Testumgebung 300 mit einem Device under Test 302, einem mixed-signal-IC, dargestellt. Auf der Generierungsseite 314 wird pro Eingangspin AWI1, der ein analoges Testsignal benötigt, eine eigene analoge Welle 304 erzeugt, während zum gleichen Zeitpunkt für einen digitalen Pin DWI1 eine digitale Welle 306 erzeugt wird.

Die Ausgangssignale AWO1 für den analogen Ausgangspin und DWO1 für den digitalen Ausgangspin werden über eine Aufnahmeeinheit für ein analoges Signal 308 und für ein digitales Signal 310 an eine gemeinsame Auswerteeinheit 312 in der Testumgebung 300 weitergeleitet, die aus den einzelnen aufgenommenen Signalen die Vorgaben für solche Tests, wie das Verhältnis der Verstärkung, der Phasenlage und der Verzögerung, der Zeitdifferenz, durchführen kann. Die Verstärkung wird zum Beispiel dadurch ermittelt, dass das Ausgangsspannungssignal zu dem Eingangsspannungssignal in Beziehung gesetzt wird. Abschließend werden die Testdaten mit Grenzwerten verglichen, um das so genannte binning, das Einteilen, ob ein mixed-signal-IC gut oder schlecht ist, durchzuführen. Findet eine signifikante Grenzwertüberschreitung bei einem Test in dem Testablauf statt, dann reagiert das Testprogramm je nach Einstellung durch einen Abbruch des Tests, sondert das mixed-signal-IC aus und führt die Tests für das nächste IC durch.

Obwohl nur einzelne Ausführungsbeispiele des erfindungsgemäßen Verfahrens beschrieben sind, ist es selbstverständlich, dass als weitere Variante des Verfahrens statt von einer Testmatrix auch von einer allgemeinen Sprache GTL als Ausgangspunkt für den Codegenerator gestartet werden kann; auch ist es selbstverständlich, dass die Matrix den Codegenerator für einen Ablauf anstoßen kann, statt dass der Codegenerator die Matrix steuert; und selbstverständlich können die Bibliotheken beliebig unterteilt werden. Alle diese Ausführungsbeispiele sind ebenfalls Teil der beschriebenen Erfindung.

## Patentansprüche

1. Verfahren, das eine IC-Tester-Steuerung, bestehend aus zahlreichen Testanweisungen, für eine Vielzahl bestimmter Testumgebungen (100, 102, 104, 300) erzeugt, die analoge und digitale Signale für ein IC, insbesondere ein mixed-signal-IC (302), erzeugen und messen können,
**dadurch gekennzeichnet, dass**
das Verfahren hierbei Daten und Steueranweisungen aus testumgebungsunabhängigen, mehrdimensionalen Testmatrizen, wie matrizenförmigen Datenbanken oder Bibliotheken (130), bezieht,
die testumgebungsunabhängigen Daten und Steueranweisungen mittels eines Codegenerators (80) in eine testumgebungsabhängige Syntax (200) gewandelt werden, die in eine testumgebungsabhängige Rahmensyntax (202) einbindbar ist, so dass die testumgebungsabhängige Syntax und die testumgebungsabhängige Rahmensyntax zusammen eine vollständige, analoge und digitale Signale umfassende Steuerung für eine der bestimmten Testumgebungen (100, 300) bilden,
die einzelnen bestimmten Testumgebungen (100, 102, 104) ihrer Struktur und/oder ihrer Syntax nach zueinander unterschiedlich sind
wobei sich die Testumgebung aus Testerhardware und Lastplatinen zusammensetzt.

2. Verfahren nach Anspruch 1, weiterhin **dadurch gekennzeichnet, dass** der Codegenerator während seiner Wandlungsphase auf eine Bibliothekengruppe (130) zurückgreift, in die verschiedene Bibliotheken (132, 134, 136, 138, 140, 142) eingebunden sind, in denen sich wenigstens teilweise Informationen bezüglich
a) der Testumgebung,
b) der testumgebungsabhängigen Syntax,
c) der Testumgebungsressourcen (132),
d) der Reihenfolge von Testverfahren,
e) der Standardfunktionen der Testumgebung,
f) der Lastplatinenstruktur (134),
g) der lastplatinenabhängigen Standardfunktionen (136) und
h) der Codegeneratoroptimierung
befinden.

3. Verfahren nach einem der vorhergehenden Ansprüche, weiterhin **dadurch gekennzeichnet, dass** eine mehrdimensionale Testmatrix
in einer ersten Dimension Daten über Anzahl und Anordnung von Kontakten des ICs hat, in einer weiteren Dimension Daten über die Bedeutung, die Namen und die Signalflussrichtung der Kontakte des ICs (I, O, P, G) hat,
in einer weiteren Dimension Ablauffolgen von Testanweisungen hat,
in einer weiteren Dimension Testanweisungsoberbegriffe hat, die einzelne Testanweisungen zusammenfassen,
in einer Dimension Testrahmenbedingungen festlegt,
in einer Dimension die Startbedingungen für einen Test festlegt,
in einer Dimension Prüfmuster festlegt,
in einer Dimension funktionale Beschreibungen der Tests festlegt,
in einer Dimension Schaltwerte festlegt,
in einer Dimension Bedingungen für eine Gütesortierung von ICs festlegt.

4. Verfahren nach einem der vorhergehenden Ansprüche, weiterhin **dadurch gekennzeichnet, dass** der Codegenerator (80) wenigstens eine der folgenden Komponenten umfasst:
- einen DC-Testgenerator (84), der die Daten und Steueranweisungen aus Matrizen ausliest und wandelt, die auf der Testumgebung Gleichspannungswerte für ein IC erzeugen,
- einen AC-Testgenerator (86), der die Daten und Steueranweisungen aus Matrizen ausliest und wandelt, die auf der Testumgebung Wechselspannungswerte oder Signalverläufe für ein IC erzeugen,
- einen Digital-Testgenerator (88), der die Daten und Steueranweisungen aus Matrizen ausliest und wandelt, die auf der Testumgebung digitale Spannungswerte für ein IC erzeugen,
- einen Lastplatinengenerator (92), der die Daten und Steueranweisungen aus Matrizen ausliest und wandelt, die auf die Resourcen und Anforderungen an die Lastbedingungen der Lastplatinen der Testumgebung Bezug nehmen,
- einen Testregelverifizierer (90), der überprüft, ob die Daten und Steueranweisungen der testumgebungsabhängigen Syntax auf der Testumgebung lauffähig sind, und der Codegenerator ein mehrstufiges Verfahren durchläuft,
- in dessen erster Stufe die Daten und Steueranweisungen einer Matrix dem Codegenerator als Quelleninformation zur Verfügung gestellt werden,
- in dessen zweiter Stufe die Quelleninformation nach und nach jeweils durch eine der Komponenten bearbeitet wird, wobei die letzte Komponente der Testregelverifizierer ist,
- und in dessen dritter Stufe die gewandelten Daten und Steueranweisungen mittels eines Optimierers (94) in Bezug auf Resourcenauslastung der Testumgebung, Testgeschwindigkeit, Testablauffolgen oder Warte- und Leerlaufzeiten zwischen einzelnen Daten und Steueranweisungen verändert werden.

5. Verfahren nach einem der vorhergehenden Ansprüche, weiterhin **dadurch gekennzeichnet, dass** als Ursprung für die testumgebungsunabhängigen Matrizen ein verarbeitbares Datenblatt (12) des ICs dient, auf dessen Grundlage aus den Matrizen automatisierte Testbeschreibungsdokumentationen erzeugt werden, die in einer allgemein lesbaren Art den Umfang, die Art, die Dauer und den Typ der Daten und Steueranweisungen benennt.

6. Verfahren nach einem der vorhergehenden Ansprüche, weiterhin **dadurch gekennzeichnet, dass** in den mehrdimensionalen Testmatrizen Testmethoden auflistbar sind, die sowohl digitale (DWI1) als auch analoge Signale (AWI1) der Steuerung der Testumgebung (100, 300) zeitlich synchron auftreten lassen.

7. Verfahren nach einem der vorhergehenden Ansprüche, weiterhin **dadurch gekennzeichnet, dass** Signale, die analog (AWI1) und/oder digital (DWI1) sind, von der Testumgebung (100, 300), vorzugsweise zeitversetzt nach dem Einprägen von Signalen der Steuerung (DWO1, AWO1), eingelesen werden, um über mixed-signal-Testmethoden, wie z. B. eine Methode zu der oder den Verstärkungen, der Spannungsverhältnisse, der Frequenzgänge, der Phasenlagen, der Wellenformen, der Harmonischen und/oder der Laufzeitverhalten, ausgewertet zu werden.

8. Datenträger, der durch einen mikroprozessorgesteuerten Rechner bearbeitbar ist, auf dem ein Verfahren nach einem der Ansprüche 1 bis 7 physikalisch verkörpert ist.

9. Mikroprozessorgesteuerter Rechner mit einem zentralen Betriebssystem, der elektrisch mit wenigstens einer Testumgebung in Verbindung steht, der für die Ausführung eines Verfahrens der Ansprüche 1 bis 7 angepasst ist.

## Claims

1. A method which generates an IC tester control consisting of numerous test instructions for a plurality of specific test environments (100, 102, 104, 300), which can generate and measure analog and digital signals for an IC, in particular a mixed-signal IC (302),
**characterized in that**
the method obtains data and control instructions from multidimensional test matrices independent of the test environment, such as matrix-like databases or libraries (130),
the data and control instructions independent of the test environment are converted by means of a code generator (80) into a syntax (200) which is dependent on the test environment and which can be integrated into a general syntax (202) dependent on the test environment, so that the syntax dependent on the test environment and the general syntax dependent on the test environment together form a complete control, comprising analog and digital signals, for one of the specific test environments (100, 300),
the individual specific test environments (100, 102, 104) differ from one another in their structure and/or their syntax,
wherein the test environment comprises tester hardware and load boards.

2. The method as claimed in claim 1, further **characterized in that**, during its conversion phase, the code generator employs a library group (130) in which are integrated various libraries (132, 134, 136, 138, 140, 142) which contain at least partially information with respect to
a) the test environment,
b) the syntax dependent on the test environment,
c) the test environment resources (132),
d) the sequence of test methods,
e) the standard functions of the test environment,
f) the load board structure (134),
g) the standard functions (136) dependent on the load board and
h) the code generator optimization.

3. The method as claimed in any of the preceding claims, further **characterized in that**, a multidimensional test matrix has,
in a first dimension, data on the number and arrangement of pins of the IC,
in a further dimension, data on the meaning, the name and the signal flow direction of the pins of the IC (I, 0, P, G),
in a further dimension, sequences of test instructions,
in a further dimension, test instruction headings which summarize individual test instructions,
in one dimension, specifies general test conditions,
in one dimension, specifies the start conditions for a test,
in one dimension, specifies test patterns,
in one dimension, specifies functional descriptions of the tests,
in one dimension, specifies switching values,
in one dimension, specifies conditions for quality sorting of ICs.

4. The method as claimed in any of the preceding claims, further **characterized in that**, the code generator (80) comprises at least one of the following components;
- a DC test generator (84) which reads out and converts the data and control instructions from matrices, which generate DC voltage values for an IC in the test environment,
- an AC test generator (86) which reads out and converts the data and control instructions from matrices, which generate AC voltage values or signal curves for an IC in the test environment,
- a digital test generator (88) which reads out and converts the data and control instructions from matrices, which generate digital voltage values for an IC in the test environment,
- a load board generator (92) which reads out and converts the data and control instructions from matrices, which refer to the resources and requirements with respect to the load conditions of the load boards of the test environment,
- a test rule verifier (90) which checks whether the data and control instructions of the syntax dependent on the test environment can be executed in the test environment,
and the code generator runs through a multistage method
- in the first stage of which the data and control instructions of a matrix are made available to the code generator as source information,
- in the second stage of which the source information is processed in succession, in each case by one of the components, the last component being the test rule verifier,
- and, in the third stage of which, the converted data and control instructions are modified by means of an optimizer (94) with respect to resource utilization of the test environment, test speed, test sequences or waiting and idle times between individual data and control instructions.

5. The method as claimed in any of the preceding claims, further **characterized in that** a processible data sheet (12) of the IC serves as the origin for the matrices independent of the test environment, on the basis of which data sheet automated test description documentations are generated from the matrices and name, in a generally legible manner, the scope, the type, the duration and the type of the data and control instructions.

6. The method as claimed in any of the preceding claims, further **characterized in that**, in the multidimensional test matrices, it is possible to list test methods which enable both digital (DWI1) and analog (AWI1) signals of the control of the test environment (100, 300) to occur synchronously.

7. The method as claimed in any of the preceding claims, further **characterized in that**, signals which are analog (AWl1) and/or digital (OWl1) are read in from the test environment (100, 300), preferably with a time lag after superposition of signals of the control (DWO1, AWO1), in order to be evaluated via mixed-signal test methods, such as, for example, a method for the gain or gains, the voltage ratios, the frequency responses, the phase positions, the wave shapes, the harmonics and/or the transit-time behavior.

8. A data medium which can be processed by a microprocessor-controlled computer on which a method as claimed in any one of the claims 1 to 7 is physically incorporated.

9. A microprocessor-controlled computer having a central operating system which is electrically connected to at least one test environment, which is adapted to the operation of a method as claimed in any one of the claims 1 to 7.

## Revendications

1. Procédé émettant une commande de test de circuit imprimé composé de multiples instructions de test pour une pluralité d'environnements de test (100, 102, 104, 300) donnés pouvant émettre et mesurer des signaux analogiques et numériques pour un circuit imprimé, notamment un circuit imprimé à signaux mixtes (302)
**caractérisé en ce que**
le procédé prend des données et des instructions de commande dans des matrices de test pluridimensionnelles indépendantes de l'environnement de test, telles que des banques de données ou des bibliothèques (130) de forme matricielle,
les données et les instructions de commande indépendantes de l'environnement de test sont converties à l'aide d'un générateur de code (80) en une syntaxe (200) dépendante de l'environnement de test pouvant être intégrée dans une syntaxe cadre (202) dépendante de l'environnement de test, de sorte que la syntaxe dépendante de l'environnement de test et la syntaxe cadre dépendante de l'environnement de test forment ensemble une commande complète comprenant les signaux analogiques et numériques d'environnements de test (100, 300) donnés,
les différents environnements de test (100, 102, 104) donnés diffèrent les uns des autres dans leur structure et/ou dans leur syntaxe,
l'environnement de test se composant de matériel de test et de platines de charge.

2. Procédé selon la revendication 1, **caractérisé en outre en ce que** le générateur de code fait appel pendant sa phase de conversion à un groupe de bibliothèques (130) dans lequel sont intégrées les différentes bibliothèques (132, 134, 136, 138, 140, 142) contenant au moins en partie les informations relatives
a) à l'environnement de test,
b) à la syntaxe dépendante de l'environnement de test,
c) aux ressources de l'environnement de test (132),
d) à l'ordre des procédés de test,
e) aux fonctions standard de l'environnement de test,
f) à la structure des platines de charge (134),
g) aux fonctions standard dépendantes des platines de charge (136) et
h) à l'optimisation du générateur de code.

3. Procédé selon l'une quelconque des revendications précédentes, **caractérisé en outre en ce qu'**une matrice de test pluridimensionnelle
a dans une première dimension des données sur le nombre et l'agencement des contacts du circuit imprimé,
a dans une autre dimension des données sur la signification, les noms et le sens de circulation des signaux des contacts du circuit imprimé (I, O, P, G),
a dans une dimension supplémentaire l'ordre de déroulement des instructions de test, a dans une dimension supplémentaire des termes génériques d'instruction de test regroupant les différentes instructions de test,
détermine dans une dimension les conditions générales de test,
détermine dans une dimension les conditions de début de test,
détermine dans une dimension les modèles de test,
détermine dans une dimension les descriptions fonctionnelles du test,
détermine dans une dimension les valeurs de commutation,
détermine dans une dimension les conditions de tri qualitatif des circuits imprimés.

4. Procédé selon l'une quelconque des revendications précédentes, **caractérisé en outre en ce que** le générateur de code (80) comprend au moins un des composants suivants :
- un générateur de courant continu (84) qui trie et convertit les données et les instructions de commande provenant des matrices produisant des valeurs de tension continue pour un circuit imprimé sur l'environnement de test,
- un générateur de tension alternative (86) qui trie et convertit les données et les instructions de commande provenant des matrices produisant des valeurs de tension alternative ou des courbes de signaux pour un circuit imprimé sur l'environnement de test,
- un générateur de test numérique (88) qui trie et convertit les données et les instructions de commande provenant des matrices produisant des valeurs de tension numérique pour un circuit imprimé sur l'environnement de test,
- un générateur de platines de charge (92) qui trie et convertit les données et les instructions de commande provenant des matrices se référant aux ressources et aux besoins relatifs aux conditions de charge des platines de charge de l'environnement de test,
- un dispositif de contrôle du réglage de test (90) qui vérifie si les données et les instructions de commande de la syntaxe dépendante de l'environnement de test peuvent fonctionner sur l'environnement de test,
et le générateur de code qui suit un procédé en plusieurs étapes,
- dans la première étape, les données et les instructions de commande d'une matrice sont mises à la disposition du générateur de code sous la forme d'informations source,
- dans la deuxième étape, les informations source sont traitées successivement par chacun des composants, le dernier composant étant le dispositif de contrôle du réglage de test,
- et dans la troisième étape, les données et les instructions de commande converties sont modifiées à l'aide d'un optimisateur (94) pour ce qui est de la charge des ressources de l'environnement de test, de la vitesse de test, de l'ordre de déroulement du test ou des temps d'attente ou de fonctionnement à vide entre les différentes données et les instructions de commande.

5. Procédé selon l'une quelconque des revendications précédentes, **caractérisé en outre en ce qu'**une feuille de données traitées (12) du circuit imprimé sert de point de départ aux matrices indépendantes de l'environnement de test à partir duquel sont créées les documentations de description de test automatisées sur les matrices expliquant par écrit de façon générale l'importance, le genre, la durée et le type des données et des instructions de commande.

6. Procédé selon l'une quelconque des revendications précédentes, **caractérisé en outre en ce que** des listes de méthodes de test sont fournies dans les matrices de test pluridimensionnelles, lesdites méthodes utilisant de façon synchrone dans le temps aussi bien les signaux numériques (DWI1) que les signaux analogiques (AWI1) de la commande de l'environnement de test (100, 300).

7. Procédé selon l'une quelconque des revendications précédentes, **caractérisé en outre en ce que** les signaux analogiques (AWI1) et/ou numériques (DWI1) sont de préférence triés de façon décalée dans le temps par l'environnement de test (100, 300) après la mise en mémoire des signaux de la commande (DWO1, AWO1), pour analyser via les méthodes à signaux mixtes, par exemple une méthode relative à l'amplification ou aux amplifications, les rapports de tension, les réponses fréquentielles, les positions de phase, les formes d'onde, les harmoniques et/ou le comportement de retard.

8. Support de données pouvant être traité par un ordinateur dirigé par le microprocesseur sur lequel un procédé selon l'une quelconque des revendications 1 à 7 est mis en oeuvre physiquement.

9. Ordinateur dirigé par un microprocesseur et muni d'un système d'exploitation central relié électriquement à au moins un environnement de test adapté à la mise en oeuvre d'un procédé selon l'une quelconque des revendications 1 à 7.
